Europäisches Patentamt

European Patent Office

Office européen des brevets

(19)

(11) Numéro de publication: **0 206 419 B1**

# (12) FASCICULE DE BREVET EUROPEEN

(45) Date de publication de fascicule du brevet: **13.05.92**   (51) Int. Cl.⁵: **H03M 1/68**, H04N 5/202, H04N 9/69

(21) Numéro de dépôt: **86201058.4**

(22) Date de dépôt: **18.06.86**

(54) **Circuit de conversion numérique-analogique muni d'une réponse non-linéaire et dispositif de visualisation à balayage cathodique équipé d'un tel circuit.**

(30) Priorité: **21.06.85 FR 8509492**

(43) Date de publication de la demande:
**30.12.86 Bulletin 86/52**

(45) Mention de la délivrance du brevet:
**13.05.92 Bulletin 92/20**

(84) Etats contractants désignés:
**DE FR GB**

(56) Documents cités:
**DE-A- 2 532 580**
**FR-A- 2 155 877**
**FR-A- 2 280 274**
**US-A- 3 705 359**
**US-A- 4 251 755**

(73) Titulaire: **LABORATOIRES D'ELECTRONIOUE PHILIPS**
**3, Avenue Descartes**
**F-94450 Limeil-Brévannes(FR)**

(84) Etats contractants désignés:
**FR**

(73) Titulaire: **N.V. Philips' Gloeilampenfabrieken**
**Groenewoudseweg 1**
**NL-5621 BA Eindhoven(NL)**

(84) Etats contractants désignés:
**DE GB**

(72) Inventeur: **Gobert, Jean**
**Société Civile S.P.I.D. 209, rue de l'Université**
**F-75007 Paris(FR)**
Inventeur: **Michel, Jean-Pierre**
**Société Civile S.P.I.D. 209, rue de l'Université**
**F-75007 Paris(FR)**

(74) Mandataire: **Landousy, Christian et al**
**Société Civile S.P.I.D. 156, Boulevard Haussmann**
**F-75008 Paris(FR)**

## Description

L'invention concerne un circuit de conversion numérique-analogique qui présente une réponse non-linéaire segmentée en fonction d'un code d'entrée constitué de p éléments-binaires Bp qui activent M étages de sortie du circuit de conversion, lesdits étages agissant sur un sommateur qui délivre un signal de sortie constitué d'une suite de segments de droite.

Elle concerne également un dispositif de visualisation à balayage cathodique équipé d'un tel circuit, notamment d'un récepteur de télévision ou un dispositif de visualisation graphique équipé d'un tel circuit, utilisés, en particulier, pour la restitution d'images synthétiques.

Un circuit de ce type est décrit dans le brevet FR 2 417 901. Ce circuit vise à indiquer un moyen permettant de perfectionner l'échelle de gradation des gris d'un signal monochrome restitué à partir de signaux couleurs rouge (R), vert (V), bleu (B), en particulier pour améliorer le comportement aux faibles luminances. La combinaison des signaux couleurs R, V, B, pondérée par des coefficients, est donc translatée pour assurer la restitution d'une luminance plus élevée aux faibles luminances.

Or, ce circuit ne traite pas la restitution d'échelle de couleurs monochromes pour chacun des signaux couleurs R, V, B, avec une restitution proportionnelle au code d'entrée. Ceci ne peut être assuré qu'en tenant compte du paramètre appelé couramment "la courbe de gamma du tube", ce qui n'est pas l'objet de ce document.

On connait également le document FR-A 2 155 877 qui décrit un convertisseur numérique-analogique délivrant un signal de sortie segmenté selon une suite de segments de droite. Ce convertisseur comprend un transcodeur-sélecteur 11a, un circuit de commande 37 et un réseau linéaire 16 de conversion en analogique. Le circuit de commande 37 reçoit $2^P$ sorties transcodées par le transcodeur 11a qui reçoit lui-même p éléments binaires. Ce convertisseur agit à partir de chaque niveau décodé et opère un décodage des p bits. Une seule des sorties du transcodeur est active à la fois. Il n'y a pas d'action unique commune sur les bits d'entrée.

On connait également le document US-A 3 705 359 qui décrit un décodeur PCM pour dilater ses caractéristiques. Il s'analyse en termes de deux convertisseurs N/A cascadés avec le premier convertisseur N/A (D1) générant un signal analogique servant de référence analogique pour le second convertisseur N/A (D2). Il n'y a pas d'action unique commune sur les bits d'entrée.

Un but de l'invention est de restituer des intensités lumineuses de couleurs monochromes variant linéairement avec un code binaire d'entrée relatif à l'intensité de chacune des couleurs R, V, B. Ceci nécessite de tenir compte de la courbe de "gamma" du tube.

Un autre but de l'invention est de définir un circuit simple et d'un faible coût, dont la courbe de réponse constitue une approximation de l'inverse de la courbe de "gamma" du tube, et permettant une extension aisée du circuit de conversion en fonction du nombre p d'éléments binaires du code d'entrée.

Un autre but de l'invention est de définir un circuit de conversion dont les variations du signal de sortie avec un code numérique d'entrée permettent d'approximer, à l'aide d'une suite de segments, des courbes présentant des pentes continûment croissantes ou continûment décroissantes.

Pour cela l'invention telle que définie dans le préambule est remarquable en ce qu'elle comprend un circuit de contrôle qui, à partir d'au moins un élément binaire, délivre au moins un signal numérique de contrôle qui active un sélecteur qui translate, en bloc, k éléments binaires des poids les plus faibles vers k étages de sortie dudit circuit de conversion avec k ≦ M-1.

Elle est également remarquable en ce que le signal de contrôle est constitué par le bit de poids le plus fort.

Ainsi, selon l'invention le circuit de contrôle opère directement sur les p bits d'entrée (donc sans transcodage) ce qui constitue un avantage important dans le domaine des circuits intégrés. L'action du circuit de contrôle ne consiste ni à agir à partir de chaque niveau décodé, ni à opérer un décodage des p bits mais à opérer une translation en bloc des bits d'entrée vers les étages de sortie à l'aide d'un signal numérique de contrôle. Le circuit de contrôle et le sélecteur selon l'invention peuvent ainsi se placer devant un réseau de conversion analogique par exemple un convertisseur N/A standard.

Cette réalisation selon l'invention est à la fois simple à mettre en oeuvre, peu onéreuse et opère rapidement (peu de couches logiques), ce qui constitue un avantage certain pour la réalisation de circuits intégrés, principalement ceux utilisés dans les secteurs de grande diffusion tels que la télévision ou les dispositifs de visualisation graphique.

Les s signaux numériques de contrôle, que délivre le circuit de contrôle, permettent de disposer de $2^s$ translations au niveau du sélecteur. Il est donc possible de disposer de $2^s$ segments pour approximer une courbe. Le nombre maximal nécessaire d'étages de sortie est alors de (p + s) pour couvrir les $2^s$ segments.

2

Dans le cas où le circuit de conversion comprend des portes logiques qui agissent sur la seconde partie des M étages de sortie, il est possible d'effectuer globalement des décalages du niveau du signal de sortie qui viennent se superposer à la segmentation en $2^s$ segments obtenue à l'aide des $\underline{s}$ signaux numériques de contrôle.

Ces portes logiques activent un des M étages de sortie. Lorsque la porte logique est une porte OU il est possible d'approximer des courbes pour lesquelles les variations de pente $\Delta Pn$ sont négatives. Lorsque la porte logique est une porte ET, il est possible d'approximer des courbes pour lesquelles les variations de pente $\Delta Pn$ sont positives.

L'invention trouve plus particulièrement son application dans l'approximation de l'inverse de la courbe de "gamma" d'un tube de visualisation à rayons cathodiques.

Un tube de réception d'images en couleurs, du genre tube cathodique, possède une réponse de transfert, tension de commande - luminance du luminophore, qui est non-linéaire. Dans le cas d'un tube-couleur, trois canons à électrons traduisent les trois tensions de commande suivant une loi de la forme : $Y = k \cdot v^\gamma$;

où v est le signal de luminance de l'image, Y est la luminance et k une constante.

Pour un tube-couleur, les trois canons ont sensiblement la même réponse avec un exposant se situant entre 1,5 et 3. Cette non-linéarité de la réponse demande que le signal de commande soit précorrigé en fournissant au récepteur de télévision ou au dispositif de visualisation graphique un signal de luminance de la forme : $v' = v^{1/\gamma}$.

C'est cette correction, appliquée à chacun des trois canons des couleurs fondamentales R, V, B, qui est effectuée par le circuit de conversion selon l'invention.

Selon un mode préférentiel de l'invention, la courbe de "gamma" est approximée selon trois segments dont les pentes décroîssent lorsque la luminance augmente.

Considérons le cas d'un code constitué de 4 éléments-binaires (p = 4) avec les (p + 2) étages constitués de sources de courant réparties selon les poids binaires suivants :

1/2, 1/4, 1/8, 1/16, 1/32 et 1/4.

Supposons qu'au code d'entrée 0000 corresponde une luminance nulle et au code d'entrée 1111 une luminance élevée.

Pour assurer ces trois segments l'invention effectue un multiplexage sur les 3 éléments-binaires de poids les plus faibles B1, B2, B3, à l'aide d'un sélecteur contrôlé par l'élément-binaire de poids le plus fort B4 :

- B4 actionne la source de courant 1/2,
- B3 actionne les sources de courant 1/4 ou 1/8,
- B2 actionne les sources de courant 1/8 ou 1/16,
- B1 actionne les sources de courant 1/16 ou 1/32.

Ainsi lorsque B4 = 0 :

- B4 est inactif sur la source de courant 1/2,
- B3 agit sur la source de courant 1/4,
- B2 agit sur la source de courant 1/8,
- B1 agit sur la source de courant 1/16.

De même lorsque B4 = 1 :

- B4 est actif sur la source de courant 1/2,
- B3 agit sur la source de courant 1/8,
- B2 agit sur la source de courant 1/16,
- B1 agit sur la source de courant 1/32.

Pour assurer un accroissement de luminance aux faibles niveaux une porte logique OU reliée à B1, B2, B3, B4 agit sur une source de courant 1/4. Elle présente l'intérêt de permettre une bonne approximation de la courbe de "gamma" et d'exploiter la mise au point d'une source de courant nécessaire par ailleurs. Cette valeur peut être modifiée et ne pas correspondre à un poids binaire.

Avec un tel circuit de conversion on obtient une échelle monotone comme l'indique le tableau I. Elle constitue une approximation satisfaisante de la courbe de gamma d'un tube à rayons cathodiques classique.

| Code | | sortie (I) |
|------|------|------------|
| 0 | 0 | 0 |
| 1 | 10/32 | 5/16 |
| 2 | 12/32 | 3/8 |
| 3 | 14/32 | 7/16 |
| 4 | 15/32 | 1/2 |
| 5 | 18/32 | 9/16 |
| 6 | 20/32 | 5/8 |
| 7 | 22/32 | 11/16 |
| 8 | 24/32 | 3/4 |
| 9 | 25/32 | 25/32 |
| 10 | 26/32 | 13/16 |
| 11 | 27/32 | 27/32 |
| 12 | 28/32 | 7/8 |
| 13 | 29/32 | 29/32 |
| 14 | 30/32 | 15/16 |
| 15 | 31/32 | 31/32 |

TABLEAU I

Un tel circuit de conversion numérique-analogique selon l'invention constitue une réalisation simple et économique de l'invention. En opérant avec plus d'éléments-binaires, par exemple 5, donc 32 pas élémentaires, il est possible d'atteindre une meilleure approximation de la courbe à approximer. Le circuit de contrôle peut aussi délivrer un plus grand nombre de signaux de contrôle pour activer le sélecteur et opérer des incréments ou des décréments de pentes bien en rapport avec la courbe.

L'invention sera mieux comprise à l'aide des figures suivantes, données à titre d'exemples non limitatifs qui représentent :

figure 1 : un schéma bloc représentant l'invention dans le cas où le circuit de conversion ne comprend pas de portes logiques activant directement un étage de sortie.

figure 2 : un schéma bloc représentant l'invention, dans le cas où le circuit de conversion comprend des portes logiques activant directement un étage de sortie, avec une représentation plus détaillée du sélecteur fournie dans le cas d'un code d'entrée à 5 éléments-binaires.

figure 3 : un schéma bloc d'une réalisation préférentielle de l'invention appliquée au cas de l'approximation de l'inverse d'une courbe de "gamma" d'un tube de visualisation.

figure 4 : un schéma logique donnant un exemple de réalisation plus détaillé du sélecteur de la figure 3.

figure 5 : deux courbes indiquant l'une l'allure d'une courbe de gamma et l'autre l'approximation obtenue à l'aide du signal de sortie du circuit de conversion selon l'invention représentée sur la figure 3.

figure 6 : deux courbes indiquant l'allure du signal de sortie du circuit de conversion selon l'invention représentée sur la figure 2 dans les cas où il existe et où il n'existe pas de portes logiques activant directement un étage de sortie.

figure 7 : un schéma bloc représentant l'invention dans le cas de l'approximation d'une courbe dont les variations de pentes sont toujours positives.

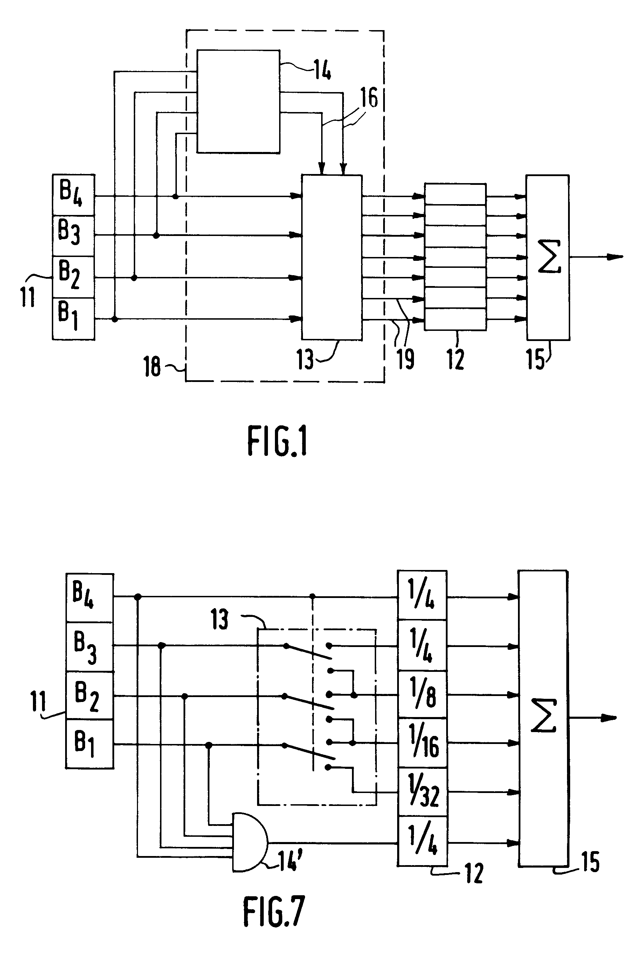

Sur la figure 1 est représenté un exemple de réalisation de l'invention avec $p = 4$ éléments binaires stockés dans le registre 11. Il est relié d'une part au sélecteur 13 et au circuit de contrôle 14 qui délivre sur les connexions 16 les s signaux numériques de contrôle qui contrôlent le sélecteur 13. Le sélecteur 13 et les moyens de contrôle 14 constituent les moyens de conversion 18 caractérisant l'invention selon un premier mode de réalisation ne comprenant pas de portes logiques agissant directement sur les étages de sortie 12. Le sélecteur 13 est relié aux étages de sortie 12 au nombre de $p + 2^s$-1 dans l'exemple représenté. Ces étages de sortie 12 sont reliés au sommateur 15 qui délivre le signal de sortie du circuit de conversion numérique analogique. Avec s signaux numériques de contrôle il est possible d'effectuer un découpage de la courbe du signal de sortie selon $2^s$ segments.

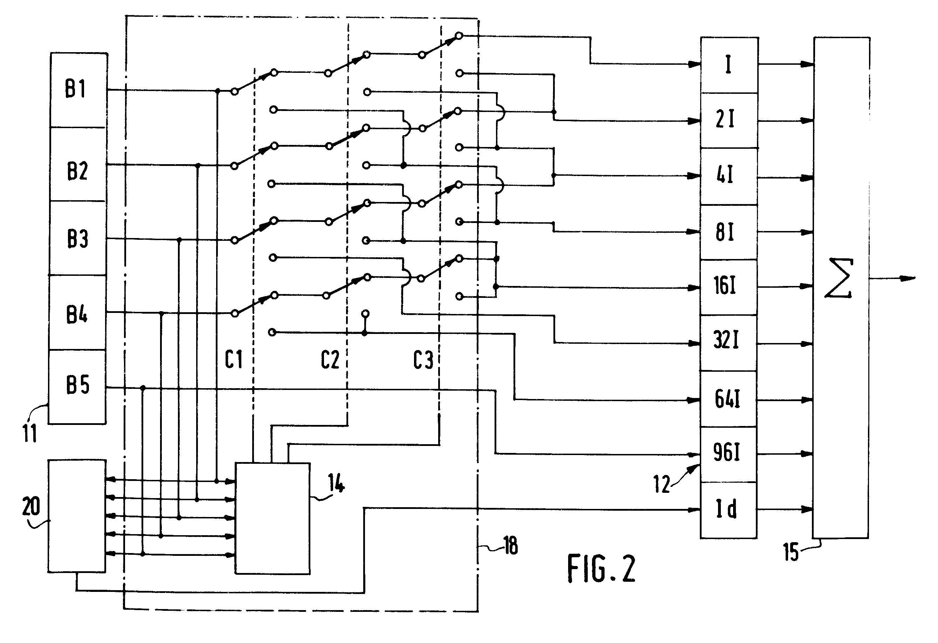

Le mécanisme de fonctionnement du sélecteur 13 est représenté plus en détail sur la figure 2, qui traite plus particulièrement du second mode de réalisation de l'invention, pour lequel en plus des moyens de conversion 18 précédents il existe des portes logiques agissant directement sur des étages de sorties reliés également au sommateur 15.

Les moyens de contrôle 14 reçoivent les 5 éléments binaires du registre 11. B1 étant l'élément binaire de poids binaire le plus faible et B5 étant l'élément binaire de poids binaire le plus élevé. Avec 5 éléments binaires on dispose de 32 configurations possibles pour le code d'entrée. Les étages de sortie 12, reliés au sélecteur, sont déterminés pour délivrer des courants selon des poids binaires. Les moyens de contrôle 14 délivrent des signaux qui actionnent le sélecteur qui décale en bloc un certain nombre de sorties du registre 11 et les oriente vers les sources de courants disposées consécutivement selon un ordre croissant (ou décroissant) de poids binaires. Ces décalages, qui affectent certains ou tous les éléments binaires du registre 11, peuvent se répéter selon $2^s$ combinaisons possibles. Selon l'allure de la courbe que l'on désire approximer il est possible de n'utiliser qu'une partie des $2^s$ combinaisons possibles.

Dans le cas de l'approximation d'une courbe de gamma d'un tube de visualisation à l'aide de 4 segments, dont les pentes varient selon des puissances de 2, le circuit de contrôle 14 délivre des signaux numériques de contrôle $C_1$, $C_2$, $C_3$ tels que $C_1 = \overline{B_4 + B_5}$, $C_2 = \overline{B_5}$, $C_3 = \overline{B_4 . B_5}$ pour lesquels :
- le symbole ( + ) représente la fonction logique OU
- le symbole (.) représente la fonction logique ET
- le symbole (-) représente la fonction logique "inversion".

Lorsque les signaux $C_1$, $C_2$ ou $C_3$ sont à l'état logique "0" ils placent les commutateurs qu'ils contrôlent dans la position haute sur la figure 2. Ils les placent dans la position basse pour l'état logique "1". Les sorties du sélecteur activent les sources de courant suivantes : I, 2I, 4I, 8I, 16I, 32I, 64I, 96I, la valeur I étant l'incrément de courant élémentaire. Il est possible de décaler en bloc le signal de sortie représentant la courbe segmentée. Ceci est réalisé à l'aide de une ou plusieurs portes logiques 20 qui activent une ou plusieurs sources de courant dont la valeur Id est déterminée par l'amplitude du décalage à obtenir.

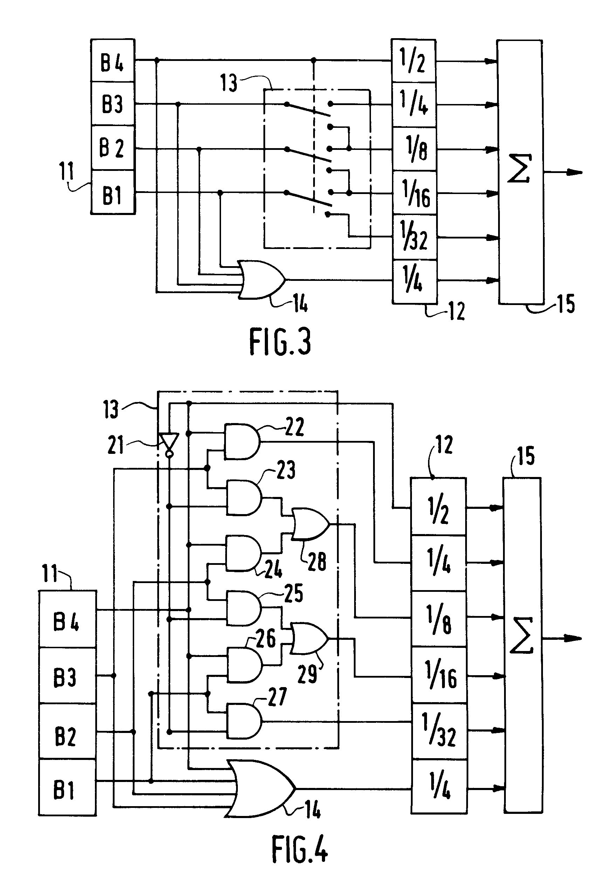

Une réalisation simplifiée avec un code d'entrée à 4 éléments binaires et une porte logique OU est représentée sur la figure 3 qui constitue un exemple préférentiel pour une réalisation économique de l'invention.

Le registre 11 stocke les 4 éléments binaires du code d'entrée. Les 6 étages, qui incrémentent le signal de sortie, tous dans cet exemple selon des poids binaires, sont indiqués par le repère 12. Ils sont constitués de 6 générateurs de courants pondérés selon les valeurs suivantes : 1/2, 1/4, 1/8, 1/16, 1/32 et 1/4. Le sélecteur 13, contrôlé par l'élément binaire de poids le plus élevé B4, oriente en bloc B1, B2 et B3, à un moment donné, vers des sources de courant différentes,
- B3 contrôle les sources de courant 1/4 ou 1/8
- B2 contrôle les sources de courant 1/8 ou 1/16
- B1 contrôle les sources de courant 1/16 ou 1/32.

Une porte logique OU 14 reçoit B1, B2, B3, B4 et délivre un signal qui contrôle une autre source de courant par exemple de valeur 1/4. L'élément binaire B4 contrôle la source de courant 1/2.

Les sorties des 6 étages 12 sont réunies à un sommateur 15 qui totalise les différents courants de sorties et intervient sur les circuits adéquats du récepteur de télésion ou du dispositif de visualisation graphique.

La figure 4 indique une représentation plus détaillée d'un exemple de réalisation du sélecteur. Celui-ci comprend :
- un inverseur 21 qui délivre un signal $\overline{B4}$ inverse du signal d'entrée B4.
- une porte ET 22 qui reçoit B4 et B3
- une porte ET 23 qui reçoit $\overline{B4}$ et B3

- une porte ET 24 qui reçoit B4 et B2
- une porte ET 25 qui reçoit $\overline{B4}$ et B2
- une porte ET 26 qui reçoit B4 et B1
- une porte ET 27 qui reçoit $\overline{B4}$ et B1
- une porte OU 28 qui reçoit les sorties des portes ET 23 et 24
- une porte OU 29 qui reçoit les sorties des portes ET 25 et 26.

Les 6 étages formés des 6 sources de courant sont contrôlés de la manière suivante :
- la source 1/2 est contrôlée par B4
- la source 1/4 est contrôlée par la sortie de la porte ET 22
- la source 1/8 est contrôlée par la sortie de la porte OU 28
- la source 1/16 est contrôlée par la sortie de la porte OU 29
- la source 1/32 est contrôlée par la sortie de la porte ET 27.

Le signal de contrôle est constitué dans ce cas par l'élément binaire B4 ainsi que par son inverse $\overline{B4}$ délivré par l'inverseur 21.

Le sélecteur 13 est représenté sous la forme de portes logiques sur la figure 4. Mais selon la technologie utilisée, il est tout à fait possible à l'Homme de métier de les remplacer par de simples transistors dans le cas d'une technologie MOS. Les transistors agissent alors en élément de transmission toujours contrôlés par B4 ou $\overline{B4}$.

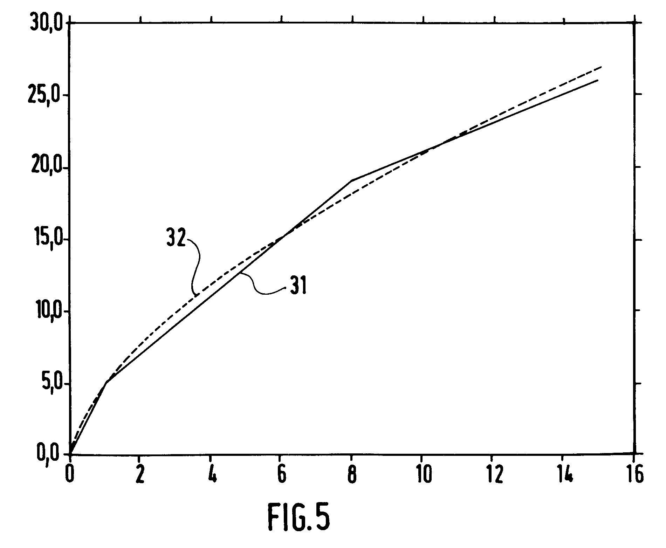

La figure 5 représente la courbe de réponse 31 du circuit de conversion selon l'invention dans le cas d'un code à 4 éléments-binaires. Elle constitue une très bonne approximation de la courbe de "gamma" 32 d'un tube à rayons cathodiques représentée avec un coefficient $\gamma = 1,5$.

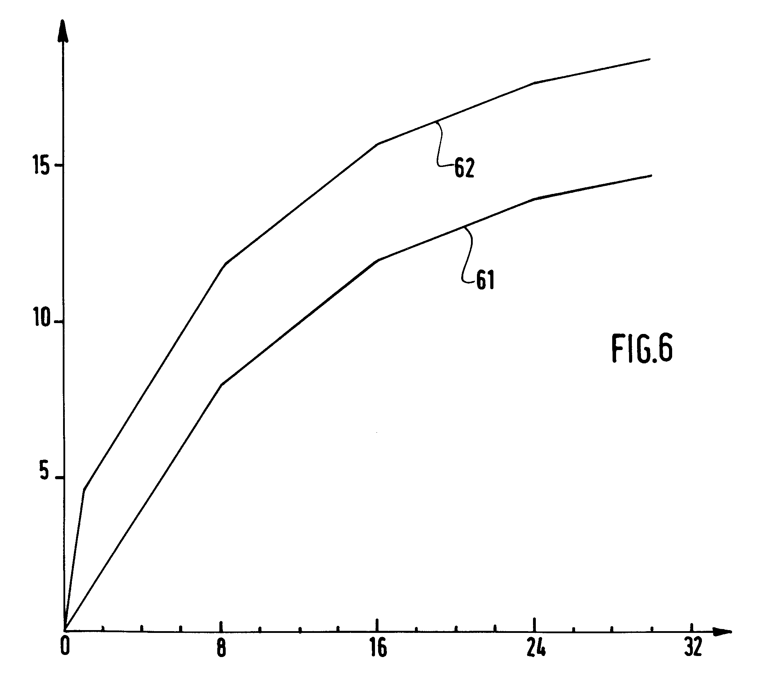

La figure 6 représente deux courbes de réponse du circuit de conversion selon l'invention dans le cas du circuit à 5 éléments binaires représenté sur la figure 2. La courbe 61 représente une approximation de la courbe de "gamma" à l'aide de 4 segments ayant des pentes décroissant à chaque fois d'une puissance de 2. Elle correspond au schéma de la figure 2 dans lequel les portes logiques 20 n'existent pas et donc n'activent pas de source de courant de valeur Id. La courbe 62 représente toujours une approximation par 4 segments de pentes décroissant à chaque fois d'une puissance de 2, mais avec en plus un premier segment à l'origine constituant un décalage de la courbe précédente 61. Ce décalage est obtenu dans ce cas à l'aide d'une porte logique OU à 5 entrées qui active la source de courant Id lorsque l'un des 5 éléments binaires d'entrée est à l'état logique 1. Le signal de sortie du circuit de conversion numérique-analogique, qui approxime une courbe de gamma d'un tube de visualisation, est adapté aux circuits habituels d'un tube de visualisation à l'aide de circuits amplificateurs habituels.

Trois circuits de conversion du type de ceux décrits dans l'invention, vont traiter séparement les trois couleurs fondamentales rouge, vert, bleu d'un système de visualisation à tubes à rayons cathodiques conventionnels. On dispose ainsi pour chaque couleur de 16 niveaux de gradation de teinte avec un code à 4 éléments-binaires qui peuvent aisément passer à 32, 64 ... niveaux de gradation en ajoutant 1, 2 ... éléments-binaires supplémentaires. Cette gradation dans les couleurs trouve son application dans la restitution d'images, en particulier celles de synthèse obtenues à l'aide de traitements informatiques. La restitution fidèle des images ainsi construites fait appel à une large étendue dans la gradation de l'intensité de chaque couleur. Le circuit de conversion, selon l'invention, reste d'une réalisation aisée même avec des codes d'entrée supérieurs à 4 éléments-binaires.

Le circuit de conversion numérique-analogique qui vient d'être décrit peut être réalisé à l'aide d'un convertisseur numérique-analogique classique muni du multiplexeur et de la porte OU. Préférentiellement, afin de réduire les coûts, tous ces éléments sont intégrés pour constituer un circuit de conversion unique.

L'invention a été décrite pour approximer une courbe du type $v^{1/\gamma}$ avec $1/\gamma \simeq 0,66$. Il est possible d'approximer une courbe du type $v^{\beta}$ avec $\beta \simeq 1,5$ à l'aide d'un circuit tout à fait équivalent. Il suffit par exemple selon la figure 7 de modifier la pondération des sources de courant des étages de sortie 12. Le registre 11 fournit les éléments binaires B1, B2, B3 au sélecteur 13, l'élément binaire B4 de poids binaire le plus élevé activant une source de courant de poids 1/4. Le sélecteur 13 est relié à des sources de courant de valeur 1/4, 1/8, 1/16, 1/32. Le sélecteur est contrôlé par l'élément binaire B4 et translate B1, B2, B3 selon deux configurations possibles. Contrairement au circuit approximant $v^{1/\gamma}$ avec $1/\gamma \simeq 0,66$, la sélection décale B1, B2, B3 vers les sources de courant de poids les plus faibles lorsque l'élément binaire B4 est à l'état logique 0 et vers les sources de courant de poids les plus élevés dans le cas inverse. Une porte logique ET 14 reçoit les quatre éléments binaires et sa sortie actionne une source de courant de valeur 1/4. Cette valeur peut ne pas présenter une valeur selon un poids binaire. On obtient ainsi une approximation d'une courbe de type $V^{\beta}$ avec $\beta \simeq 1,5$ donc présentant une pente croissante Pn, soit une variation $\Delta Pn$ toujours positive.

6

**Revendications**

1. Circuit de conversion numérique-analogique qui présente une réponse non-linéaire segmentée en fonction d'un code d'entrée constitué de p éléments-binaires Bp (11) qui activent M étages de sortie (12) du circuit de conversion, lesdits étages agissant sur un sommateur (15) qui délivre un signal de sortie constitué d'une suite de segments de droite Sn de pente PSn de sorte que la pente de deux segments consécutifs est telle que $PSn+1 = PSn + \Delta Pn$ où $\Delta Pn$ garde le même signe pour la totalité de réponse non-linéaire segmentée caractérisé en ce qu'il comprend un circuit de contrôle (14) qui, à partir d'au moins un élément binaire, délivre au moins un signal numérique de contrôle qui active un sélecteur (13) qui translate, en bloc, k éléments binaires des poids les plus faibles vers k étages de sortie dudit circuit de conversion avec $k \leq M-1$.

2. Circuit de conversion numérique-analogique selon la revendication 1 caractérisé en ce que le signal de contrôle est constitué par le bit de poids le plus fort.

3. Circuit de conversion numérique-analogique selon une des revendications 1 ou 2 caractérisé en ce qu'il comprend au moins une porte logique (20) assurant une combinaison de certains éléments binaires qui active une autre partie des M étages de sortie (12).

4. Circuit de conversion numérique-analogique selon la revendication 3 caractérisé en ce qu'il s'agit d'une porte logique OU (14) afin que les variations de pentes de deux segments consécutifs soient négatives.

5. Circuit de conversion numérique-analogique selon la revendication 3 caractérisé en ce qu'il s'agit d'une porte logique ET (14') afin que les variations de pentes de deux segments consécutifs soient positives.

6. Application du circuit de conversion selon la revendication 4 pour approximer l'inverse de la courbe de "gamma" d'un tube de visualisation à rayons cathodiques.

**Claims**

1. A digital-analog conversion circuit having a non-linear response which is segmented as a function of an input code consisting of p binary elements Bp (11) which activate M output stages (12) of the conversion circuit, said stages acting on a summing device (15) which supplies an output signal constituted by a series of line segments Sn of slope PSn such that the slope of two consecutive segments is such that $PSn + 1 = PSn + \Delta Pn$, where $\Delta Pn$ retains the same sign for the whole of the segmented non-linear response, characterized in that it comprises a control circuit (14) which, from at least one binary element, supplies at least one digital control signal which activates a selector (13) shifting all the k lowest-weighted binary elements towards k output stages of said conversion circuit, with $k \leq M-1$.

2. A digital-analog conversion circuit as claimed in Claim 1, characterized in that the control signal is constituted by the bit of the highest weight.

3. A digital-analog conversion circuit as claimed in any one of Claim 1 or 2, characterized in that it comprises at least one logic gate (20) ensuring a combination of certain binary elements which activate another part of M output stages (12).

4. A digital-analog conversion circuit as claimed in Claim 3, characterized in that the logic gate is an OR gate (14) ensuring that the variations in the slopes of the two consecutive segments are negative.

5. A digital-analog conversion circuit as claimed in Claim 3, characterized in that the logic gate is an AND gate (14') ensuring that the variations of the slopes of the two consecutive segments are positive.

6. Use of a conversion circuit as claimed in Claim 4 for approximating the inverse of the "gamma" curve of a cathode ray display tube.

**Patentansprüche**

1. Digital-Analog-Umsetzerschaltung, die eine nichtlineare segmentierte Signalantwort als Funktion eines aus p Binärelementen Bp (11) gebildeten Eingangseodes, die M Ausgangsstufen (12) der Umsetzer-Schaltung aktivieren, darstellt, wobei die Stufen auf einen Addierer (15) wirken, der ein aus einer Folge von Segmenten $S_n$ von Geraden der Steigung $PS_n$ gebildetes Ausgangssignal liefert, derart, daß die Steigung der beiden aufeinanderfolgenden Segmente so ist, daß $PS_{n+1} = PS_n + \Delta P_n$ ist, worin $\Delta P_n$ das gleiche Vorzeichen für die Gesamtheit der nichtlinearen segmentierten Signalantwort behält, dadurch gekennzeichnet, daß sie eine Steuerschaltung (14) enthält, die von mindestens einem Binärelement ausgehend mindestens ein digitales Steuersignal liefert, das einen Wähler (13) aktiviert, der k Binärelemente mit niedrigstem Stellenwert nach k Ausgangsstufen der Umsetzerschaltung, mit k ≦ M-1, auf einmal verschiebt.

2. Digital-Analog-Umsetzerschaitung nach Anspruch 1, dadurch gekennzeichnet, daß das Steuersignal von dem Bit mit höchstem Stellenwert gebildet wird.

3. Digital-Analog-Umsetzerschaltung nach Anspruch 1 oder 2, dadurch gekennzeichnet, daß sie mindestens ein Logikglied (20) enthält, das eine Kombination bestimmter Binärelemente gewährleistet, die einen anderen Teil der M Ausgangsstufen (12) aktiviert.

4. Digital-Analog-Umsetzerschaltung nach Anspruch 3, dadurch gekennzeichnet, daß es sich um ein logisches ODER-Glied (14) handelt, damit die Änderungen der Steigungen zweier aufeinanderfolgender Elemente negativ sind.

5. Digital-Anaiog-Umsetzerschaltung nach Anspruch 3, dadurch gekennzeichnet, daß es sich um ein logisches UND-Glied (14') handelt, damit die Änderungen der Steigungen zweier aufeinanderfolgender Elemente positiv sind.

6. Anwendung der Umsetzerschaltung nach Anspruch 4, um das Inverse der "Gamma"-Kurve einer Kathodenstrahlbildröhre anzunähern.

FIG.1

FIG.7

FIG.2

FIG.3

FIG.4

FIG.5

FIG.6